# EUROPEAN PATENT SPECIFICATION

(11) **EP 1 489 645 B1**
(45) Date of publication and mention of the grant of the patent: **29.12.2010**
(21) Application number: 03715380.6
(22) Date of filing: 19.03.2003
(51) Int. Cl.: H01L 21/205, H01L 21/31, C23C 16/44

(54) **CVD APPARATUS AND METHOD OF CLEANING THE CVD APPARATUS**
CVD-VORRICHTUNG UND VERFAHREN ZUR REINIGUNG DER CVD-VORRICHTUNG
DISPOSITIF CVD ET PROCEDE DE NETTOYAGE D'UN DISPOSITIF CVD

(30) Priority: 27.03.2002 JP 2002089077; 05.06.2002 JP 2002164688
(43) Date of publication of application: 22.12.2004
(73) Proprietor: National Institute of Advanced Industrial Science and Technology, Tokyo 100-8921 (JP); ULVAC, INC., Chigasaki-shi Kanagawa 253-8543 (JP); Kanto Denka Kogyo Co., Ltd., Chiyoda-ku, Tokyo 100-0005 (JP); Canon Anelva Corporation, Asao-ku Kawasaki-shi Kanagawa 215-8550 (JP); Sanyo Electric Co., Ltd., Moriguchi-shi Osaka, 570-8677 (JP); SHOWA DENKO K.K., Tokyo 105-8518 (JP); Sony Corporation, Tokyo 108-0075 (JP); Tokyo Electron Limited, Tokyo 107-6325 (JP); Panasonic Corporation, Kadoma-shi Osaka 571-8501 (JP); Hitachi Kokusai Electric Inc., Chiyoda-ku, Tokyo 101-8980 (JP); Mitsubishi Electric Corporation, Tokyo 100-8310 (JP); Renesas Electronics Corporation, Kanagawa 211-8668 (JP)
(72) Inventor: SAKAI, K., RESEARCH INSTIT. INNOVATIVE TECH. EARTH, Kyoto 619 0292 (JP); OKURA, S., RESEARCH INSTIT. INNOVATIVE TECH. EARTH, Kyoto 619 0292 (JP); SAKAMURA, M., RESEARCH INSTIT. INNOVT. TECH. EARTH, Kyoto 619 0292 (JP); ABE, K., RESEARCH INSTIT. INNOVATIVE TECH. EARTH, Kyoto 619 0292 (JP); MURATA, H., RESEARCH INSTIT. INNOVAT. TECH. EARTH, Kyoto 619 0292 (JP); WANI, E., RESEARCH INSTIT. INNOVAT. TECH. EARTH, Kyoto 619 0292 (JP); KAMEDA, K., RESEARCH INSTIT. INNOVAT. TECH. EARTH, Kyoto 619 0292 (JP); MITSUI, Y., RESEARCH INSTIT. INNOVAT. TECH. EARTH, Kyoto 619 0292 (JP); OHIRA, Y., RESEARCH INSTIT. INNOVATIVE TECH. EARTH, Kyoto 619 0292 (JP); YONEMURA, T., RESEARCH INSTIT. INNOVT. TECH. EARTH, Kyoto 619 0292 (JP); SEKIYA, A., TSUKUBA CNTR. NTNL. INST. AD. IND. S&T, Tsukuba-shi, Ibaraki 305 (JP)
(74) Representative: Jackson, Robert Patrick
(86) International application number: PCT/JP2003/003336
(87) International publication number: WO 2003/081651

(56) References cited:
- EP-A- 1 164 628
- EP-A2- 1 164 628
- JP-A- 2001 332 498
- JP-A- 2002 033 315
- JP-A- 2003 017 416
- US-B1- 6 277 173

## Description

The present invention relates to a chemical vapor deposition (CVD) apparatus for forming a uniform thin film of high quality, for example, silicon oxide (SiO₂) or silicon nitride (Si₃N₄ or the like) on a surface of a base material for a semiconductor such as a silicon wafer.

In more detail, the present invention relates to a CVD apparatus capable of executing cleaning for removing a by-product adhered to an inner wall of a reaction chamber or the like after a thin film forming process, and a method of cleaning the CVD apparatus using the CVD apparatus.

Conventionally, a thin film such as silicon oxide (SiO₂) or silicon nitride (Si₃N₄ or the like) is widely used in a semiconductor element such as a thin film transistor, a photoelectric converting element or the like. The following three kinds of techniques for forming a thin film such as silicon oxide, silicon nitride or the like are mainly used.
(1) Physical vapor-phase film forming technique such as sputtering or vacuum deposition
   more specifically, a technique for converting a solid thin film material to an atom or an atomic group to be physical means and depositing the same on a surface of a formed film, thereby forming a thin film;
(2) Thermal CVD technique
   more specifically, a technique for heating a gaseous thin filmmaterial to a high temperature so as to induce chemical reaction, thereby forming a thin film; and
(3) Plasma CVD technique
   more specifically, a technique for converting a gaseous thin filmmaterial to a plasma so as to induce chemical reaction, thereby forming a thin film.

In particular, the plasma CVD technique (plasma enhanced chemical vapor deposition) in (3) is widely used because a minute and uniform thin film can efficiently be formed.

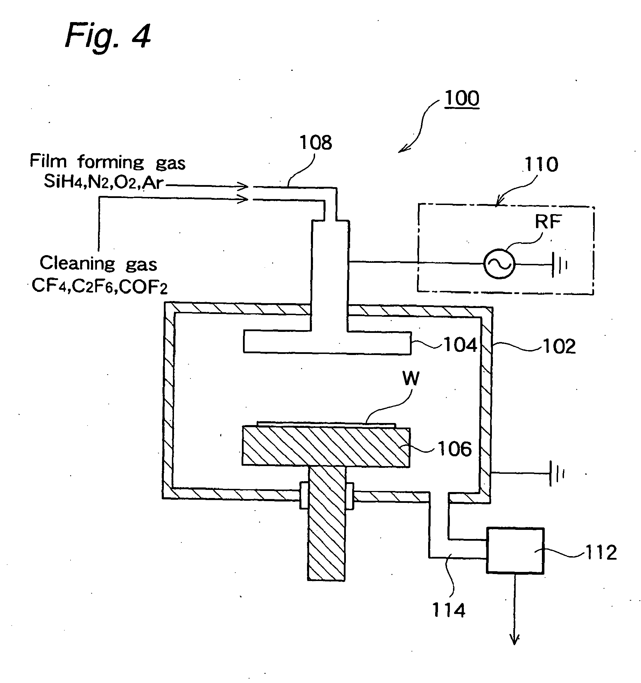

A plasma CVD apparatus 100 to be used in the plasma CVD technique is generally constituted as shown in Fig. 4.

More specifically, the plasma CVD apparatus 100 comprises a reaction chamber 102 maintained in a decompression state, and an upper electrode 104 and a lower electrode 106 are provided to be opposed apart from each other at a constant interval in the reaction chamber 102. A film forming gas supply path 108 connected to a film forming gas source (not shown) is connected to the upper electrode 104, and a film forming gas is supplied into the reaction chamber 102 through the upper electrode 104.

Moreover, a high frequency applicator 110 for applying a high frequency is connected to the reaction chamber 102 in the vicinity of the upper electrode 104. Furthermore, an exhaust path 114 for exhausting a gas through a pump 112 is connected to the reaction chamber 102.

In the plasma CVD apparatus 100 thus constituted, for example, monosilane (SiH₄), N₂O, N₂, O₂, Ar and the like in the formation of the film of silicon oxide (SiO₂) and monosilane (SiH₄), NH₃, N₂, O₂, Ar and the like in the formation of the film of silicon nitride (Si₃N₄ or the like) are introduced through the film forming gas supply path 108 and the upper electrode 104 into the reaction chamber 102 maintained in a decompression state of 130 Pa, for example. In this case, a high frequency power of 13.56 MHz is applied between the electrodes 104 and 106 provided opposite to each other in the reaction chamber 102 through the high frequency applicator 110, for example. As a result, a high frequency electric field is generated, electrons are impacted with neutral molecules of a film forming gas in the electric field, and a high frequency plasma is formed so that the film forming gas is dissociated into ions and radicals. By the actions of the ions and radicals, a silicon thin film is formed on a surface of a semiconductor product W such as a silicon wafer which is provided on one of the electrodes (the lower electrode 106).

In such a plasma CVD apparatus 100, at a film forming step, a thin film material such as SiO₂ or Si₃N₄ is also adhered to and deposited on the surfaces of an inner wall, an electrode and the like in the reaction chamber 102 other than the semiconductor product W to be formed so that a by-product is obtained by a discharge in the reactive chamber 102. When this by-product grows to have a constant thickness, it is peeled by a dead weight, a stress or the like. At the film forming step, consequently, fine particles to be foreign matters are mixed into the semiconductor product so that contamination is caused. For this reason, a thin film of high quality cannot be manufactured so that the disconnection or short-circuit of a semiconductor circuit is caused. In addition, there is a possibility that a yield or the like might be deteriorated.

For this reason, conventionally, a by-product is removed by using, for example, a cleaning gas obtained by adding a fluorocompound such as CF₄, C₂F₆ or COF₂, and O₂ or the like if necessary in order to remove such a by-product at any time after the film forming step is ended in the plasma CVD apparatus 100.

More specifically, in a method of cleaning the conventional plasma CVD apparatus 100 using such a cleaning gas, a cleaning gas containing a fluorocompound such as CF₄, C₂F₆ or COF₂ is accompanied by a gas such as O₂ and/or Ar in place of a film forming gas in film formation and the cleaning gas is introduced into the reaction chamber 102 maintained in a decompression state through the film forming gas supply path 108 and the upper electrode 104 after the film forming step is ended as shown in Fig. 4. In the same manner as the film formation, a high-frequency power is applied between the electrodes 104 and 106 provided opposite to each other in the reaction chamber 102 through the high-frequency applicator 110. As a result, a high frequency electric field is generated, electrons are impacted with the neutral molecules of the cleaning gas in the electric field, and a high frequency plasma is formed so that the cleaning gas is dissociated into ions and radicals. The ions and the radicals react to a by-product such as SiO₂ or Si₃N₄ which is adhered to and deposited on the surfaces of the inner wall, the electrode and the like in the reaction chamber 102 so that the by-product is gasified as SiF₄ and is discharged to the outside of the reaction chamber 102 through the exhaust path 114 together with an exhaust gas by the action of the pump 112.

The fluorocompound such as CF₄ or C₂F₆ to be used as the cleaning gas is a stable compound having a long life in the atmospheric air, and furthermore, there is a problem in that a gas discharging process is hard to perform after the cleaning and a disposal cost is increased. Moreover, global warming coefficient potential (values for a cumulative period of 100 years) of CF₄, C₂F₆ and SF₆ are 6500, 9200 and 23900 respectively, and they are extremely large. Therefore, an adverse influence thereof on an environment is apprehended.

Moreover, the ratio of a gas to be discharged to the outside of the reaction chamber 102 through the exhaust path 114 is high, that is, approximately 60% in case of C₂F₆, for example, and currently, it has an adverse influence on global warming and a dissociation efficiency is low and a cleaning capability is also low.

In addition, a by-product generated from the reaction chamber 102 is also adhered to the side wall of the piping of the exhaust path 114 or the like. In some cases, consequently, the exhaust path 114 is closed, resulting in a deterioration in a film forming efficiency and a gas utilization efficiency.

In consideration of such actual circumstances, it is an object of the present invention to provide a CVD apparatus capable of executing cleaning in which a by-product such as SiO₂ or Si₃N₄ adhered to and deposited on the surfaces of an inner wall, an electrode and the like in a reaction chamber and the side wall of the piping of the exhaust path or the like can efficiently be removed at a film forming step, and furthermore, the amount of a cleaning gas to be discharged is very small, the influence on an environment such as global warming is also lessened, a gas utilization efficiency is also high and a cost can also be reduced, and manufacturing a thin film of high quality. Furthermore, the object of the present invention is also to provide a method of cleaning the CVD apparatus using the CVD apparatus.

EP 1164628 A2 relates to a process for using cleaning gases more efficiently in a semiconductor processing chamber. A portion of cleaning gases exhausted from a chamber are recycled via a plasma source and re-introduced into the chamber to further clean the chamber.

US 6277173 B1 relates to re-use of gas discharged from a vacuum pump. Discharged gases are detoxified, compressed and filtered, then stored for re-use.

The present invention has been made in order to solve the problems and to attain the object in the prior art described above. According to a first aspect, the present invention provides a CVD apparatus for supplying a reactive gas into a reaction chamber and forming a deposited film on a surface of a base material provided in the reaction chamber, wherein an exhaust path for exhausting a gas through a dry pump and a toxicity removing device from an inner part of the reaction chamber is provided with an exhaust gas recycling path for recycling the exhaust gas, which is branched from a downstream side of the dry pump and an upstream side of the toxicity removing device to an upstream side of the dry pump on the exhaust path, a plasma generating device is provided on the exhaust gas recycling path, and the exhaust gas recycling path is provided with a reaction chamber recycling path for recycling the exhaust gas to the reaction chamber.

Moreover, according to a second aspect, the present invention provides a method of cleaning a CVD apparatus in which a reactive gas is supplied into a reaction chamber through a reactive gas supply path and a deposited film is formed on a surface of a base material provided in the reaction chamber, and an inner part of the reaction chamber is then cleaned, wherein an exhaust gas is converted to a plasma and the exhaust gas is recycled to an upstream side of a dry pump on an exhaust path through an exhaust gas recycling path, which is branched from a downstream side of the dry pump and an upstream side of a toxicity removing device on the exhaust path for exhausting a gas from the inner part of the reaction chamber through the dry pump and the toxicity removing device, so that an inner part of a piping is cleaned, a reaction chamber recycling path for recycling the exhaust gas to the reaction chamber is provided on the exhaust gas recycling path, and the inner part of the reaction chamber is cleaned through the reaction chamber recycling path.

By such a structure, the inner part of the reaction chamber can be cleaned, and furthermore, a by-product such as SiO₂ or Si₃N₄ adhered to the piping such as the exhaust path or the exhaust gas recycling path can be cleaned while the exhaust gas converted to a plasma by a plasma generating device is recycled to the upstream side of the exhaust path through the exhaust gas recycling path. Consequently, the piping can be prevented from being closed. Thus, it is possible to enhance a film forming efficiency and a gas utilization efficiency.

Accordingly, the by-product such as SiO₂ or Si₃N₄ adhered to and deposited on the inner part of the reaction chamber can be removed. In film formation, therefore, the mixture of fine particles into a semiconductor product and contamination thereof can be eliminated, a thin film of high quality can be manufactured and a yield or the like can also be enhanced.

Moreover, the cleaning gas component discharged finally to the outside is very lessened. Therefore, the amount of the discharge of the cleaning gas is also very small and an influence on an environment such as global warming can also be lessened.

Furthermore, because the exhaust gas recycling path is constituted to recycle the exhaust gas from a downstream side of a dry pump to the upstream side of the exhaust path, a pressure is raised and the generation of particles is eliminated, and the clogging of a filter is lessened and the particles are not recycled into the reaction chamber. Consequently, a cleaning effect can be enhanced.

Moreover, in a preferred embodiment, the present invention comprises a polymer film device for absorbing and removing an inactive gas in the exhaust gas is provided on the exhaust gas recycling path.

With such a structure, an inactive gas such as N₂ or O₂ can be absorbed and removed by the polymer film device, for example. Therefore, it is possible to clean the piping of the exhaust path, the exhaust gas recycling path or the like by recycling only the cleaning gas component to the upstream side of the exhaust path. Consequently, the gas utilization efficiency can be enhanced. Moreover, it is possible to recover and recycle the inactive gas thus absorbed and removed.

Furthermore, in a preferred embodiment, the present invention comprises a separator for selectively removing an unnecessary exhaust gas component is provided on the exhaust gas recycling path.

By such a structure, an unnecessary exhaust gas component such as SiF₄, HF, CO or CO₂ is selectively removed by the separator. For example, therefore, it is possible to carry out the cleaning by recycling a cleaning gas component such as COF₂, CF₄ or F₂ or a concentrated gas component into the reaction chamber. Consequently, the gas utilization efficiency can be enhanced.

Moreover, in a preferred embodiment the exhaust gas recycling path is provided with a compressor for raising a pressure of the exhaust gas and recycling the exhaust gas to the upstream side of the exhaust path.

By the compressor, thus, the pressure of the exhaust gas, that is, the cleaning gas is raised and the gas is recycled to the upstream side of the exhaust path. Therefore, a pressure in the piping of the exhaust path, the exhaust gas recycling path or the like can be held to be constant. Consequently, it is possible to maintain the cleaning effect to be constant.

Furthermore, in a preferred embodiment, the exhaust gas recycling path is provided with a control device for detecting a component of the exhaust gas recycled to the upstream side of the exhaust path and causing the gas component to be constant.

By such a structure, for example, the concentration of COF₂ flowing in the exhaust gas recycling path, is monitored by the control device. Consequently, the cleaning gas component in the piping of the exhaust path, the exhaust gas recycling path or the like can be maintained in a constant stationary state. Therefore, it is possible to execute uniform and efficient cleaning.

Moreover, in a preferred embodiment of the present invention, the exhaust gas recycling path is provided with a pressure releasing device for releasing a pressure when the exhaust gas recycling path has a constant pressure or more.

By such a structure, the pressure is released by the pressure releasing device when the pressure of the exhaust gas recycling path is a constant pressure or more. Therefore, it is possible to prevent a rise in the pressure of the exhaust gas recycling path which causes the breakage and damage of apparatuses such as the piping of the exhaust path or the exhaust gas recycling path, the pump, the polymer film device and the separator.

Furthermore, in a preferred embodiment, a switching device for switching the exhaust gas recycling path and a reactive gas supply path is provided, the exhaust gas recycling path is opened when a cleaning gas is to be introduced into the reaction chamber through the reactive gas supply path to clean an inner part of the reaction chamber, and a switching control is carried out by the switching device to close the exhaust gas recycling path when a deposited film is to be formed on a surface of a base material in the reaction chamber.

Moreover, in a preferred embodiment, a switching device for switching the exhaust gas recycling path and a reactive gas supply path is provided, the exhaust gas recycling path is opened when a cleaning gas is to be introduced into the reaction chamber through a remote plasma generating device to clean an inner part of the reaction chamber, and a switching control is carried out by the switching device in order to close the exhaust gas recycling path when a deposited film is to be formed on the surface of the base material in the reaction chamber.

By such a structure, the exhaust gas recycling path is opened in the cleaning. Therefore, the inner part of the piping of the exhaust path or the exhaust gas recycling path is cleaned while the exhaust gas is recycled to the upstream side of the exhaust path through the exhaust gas recycling path. Consequently, it is possible to use the cleaning gas component contained in the exhaust gas as a cleaning gas for cleaning the inner part of the piping of the exhaust path or the exhaust gas recycling path again. Consequently, the gas utilization efficiency can be enhanced.

On the other hand, when a deposited film is to be formed on the surface of the base material in the reaction chamber, the exhaust gas recycling path is closed. Consequently, it is possible to hold a film forming gas component to be constant. Thus, it is possible to form a uniform thin film of constant quality on the base material.

Since in the present invention the exhaust gas recycling path is provided with a reaction chamber recycling path for recycling the exhaust gas to the reaction chamber, the inner part of the reaction chamber is cleaned while the exhaust gas is recycled to the reaction chamber through the reaction chamber recycling path. Therefore, a cleaning gas component contained in the exhaust gas can be used again as a cleaning gas in the reaction chamber. Consequently, the gas utilization efficiency can be enhanced.

Accordingly, a by-product such as SiO₂ or Si₃N₄ adhered to and deposited on the inner part of the reaction chamber can be removed. In film formation, therefore, the mixture of fine particles into a semiconductor product and contamination thereof can be eliminated, a thin film of high quality can be manufactured and a yield or the like can also be enhanced.

Moreover, the cleaning gas component discharged finally to the outside is very lessened. Therefore, the amount of the discharge of the cleaning gas is also very small and an influence on an environment such as global warming can also be lessened.

Furthermore, in one embodiment, the reactive gas supply path is opened and the exhaust gas recycling path and the reaction chamber recycling path are opened if necessary in an initial stage of the cleaning during the cleaning, and
a switching control is carried out by the switching device, in order to close the reactive gas supply path to carry out the cleaning after the cleaning progresses.

In addition, in one embodiment, the reactive gas supply path is opened and the exhaust gas recycling path and the reaction chamber recycling path are opened if necessary in an initial stage of the cleaning during the cleaning, and
the reactive gas supply path is closed to carry out the cleaning after the cleaning progresses.

Moreover, in a further embodiment of the CVD apparatus, a cleaning gas supply path from a remote plasma generating device is opened and the exhaust gas recycling path and the reaction chamber recycling path are opened if necessary in an initial stage of the cleaning during the cleaning, and
a switching control is carried out by the switching device in order to close the cleaning gas supply path to carry out the cleaning after the cleaning progresses.

Furthermore, in another embodiment of the method of cleaning a CVD apparatus, when a cleaning gas is to be introduced into the reaction chamber through the remote plasma generating device, thereby cleaning an inner part of the reaction chamber, a cleaning gas supply path from a remote plasma generating device is opened and the exhaust gas recycling path and the reaction chamber recycling path are opened if necessary in an initial stage of the cleaning, and the reactive gas supply path is closed to carry out the cleaning after the cleaning progresses.

By such a structure, after the cleaning gas, for example, C₂F₆ is caused to flow for a constant time, COF₂ is generated. Therefore, the COF₂ is recycled by the exhaust gas recycling path and the reaction chamber recycling, path and can be thus used as the cleaning gas. Consequently, the utilization efficiency of the cleaning gas can be enhanced and a cost can also be reduced.

Preferably, after a film forming process for a substrate is carried out by the CVD apparatus, a cleaning gas to be used for removing a by-product adhered into the reaction chamber is a cleaning gas containing a fluorine gas.

By using the cleaning gas containing the fluorine gas, thus, it is possible to stably generate a plasma and to obtain an excellent cleaning uniformity.

Preferred embodiments (examples) of the present invention will now be described by way of example only and with reference to the drawings, in which:
Fig. 1 is a schematic view showing a first embodiment of a CVD apparatus according to the present invention.
Fig. 2 is a schematic view showing a second embodiment of the CVD apparatus according to the present invention.
Fig. 3 is a schematic view showing a third embodiment of the CVD apparatus according to the present invention.
Fig. 4 is a schematic view showing a plasma CVD apparatus to be used for a conventional plasma CVD method.

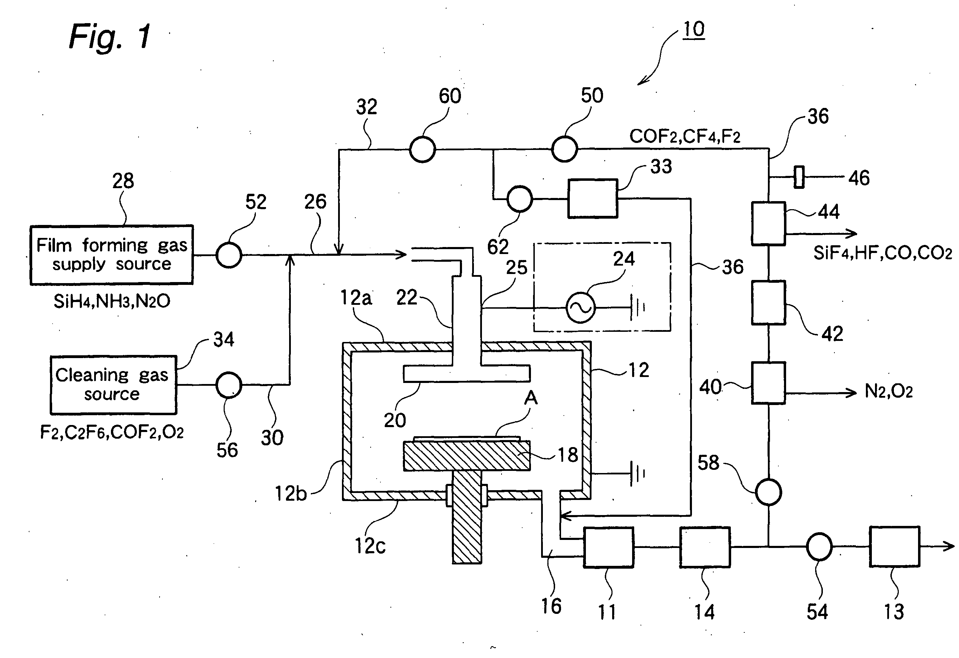

As shown in Fig. 1, a plasma CVD apparatus 10 to be used for a plasma CVD method comprises a reaction chamber 12 maintained in a decompression state (a vacuum state). Furthermore, the plasma CVD apparatus 10 is maintained in a constant vacuum state (a decompression state) by discharging an internal gas to the outside through an exhaust path 16 formed on a bottom wall 12c of the reaction chamber 12, by means of a mechanical booster pump 11, a dry pump 14 and a toxicity removing device 13 for causing an exhaust gas to be nontoxic.

Moreover, a lower electrode 18 constituting a stage for mounting a base material A to deposit (vapor deposit) a silicon thin film on a surface of a silicon wafer or the like, for example, is provided in the reaction chamber 12. The lower electrode 18 penetrates through the bottom wall 12c of the reaction chamber 12 and is constituted vertically slidably by a driving mechanism which is not shown, and a position can be adjusted. A sliding portion between the lower electrode 18 and the bottom wall 12c is provided with a seal member such as a seal ring which is not shown, in order to maintain a degree of vacuum in the reaction chamber 12.

On the other hand, an upper electrode 20 is provided in the upper part of the reaction chamber 12, and has a base end portion 22 thereof which penetrates through a top wall 12a of the reaction chamber 12 and is connected to a high frequency power source 24 provided on the outside of the reaction chamber 12. The upper electrode 20 is provided with a high frequency applicator 25 such as a high frequency application coil which is not shown. In addition, andamatching circuit (not shown) is provided between the high frequency applicator 25 and the high frequency power source 24. Consequently, it is possible to propagate a high frequency generated by the high frequency power source 24 to the high frequency applicator 25 such as the high frequency application coil without a loss.

Moreover, a reactive gas supply path 26 is formed on the upper electrode 20, and a film forming gas is introduced from a film forming gas supply source 28 into the reaction chamber 12 maintained in a decompression state, through the reactive gas supply path 26 and the upper electrode 20.

On the other hand, a cleaning gas supply path 30 is branched and connected to the reactive gas supply path 26. As a result, and a cleaning gas can be introduced from a cleaning gas source 34 into the reaction chamber 12 through the cleaning gas supply path 30.

Moreover, a reaction chamber recycling path 32, which is branched from the downstream side of the dry pump 14 in the exhaust path 16 and is reached to the reactive gas supply path 26 is provided. In addition, an exhaust gas recycling path 36 which is branched in the middle and is served to recycle the exhaust gas to be recycled to the upstream side of the exhaust path 16. The exhaust gas recycling path 36 serves to recycle the exhaust gas of the cleaning gas introduced into the reaction chamber 12 to the upstream side of the exhaust path 16 after the exhaust gas is converted to a plasma by a plasma generating device 33 in cleaning which will be described below.

The plasma generating device 33 is not particularly restricted but it is possible to use ASTRON (trade name) manufactured by ASTEX Co., Ltd. or the like.

The exhaust gas recycling path 36 is provided with a polymer film device 40 for absorbing and removing an inactive gas such as N₂ or O₂ in the exhaust gas. Such a polymer film device 40 is not particularly restricted but can use a polymer film such as polysulfone or a hollow fiber film.

It is possible to provide a separator 44 on the downstream of the polymer film device 40 through a compressor 42 for raising a pressure to 0.01 to 0.5 MPa, for example, if necessary. By the separator 44, for example, it is also possible to propose that an unnecessary exhaust gas component such as SiF₄, HF, CO or CO₂ is selectively removed.

Furthermore, a gas analyzing sensor 46 is provided on the exhaust gas recycling path 36. Consequently, the component of the exhaust gas in the exhaust gas recycling path 36 which is recycled into the reaction chamber 12 is detected. Then, the amounts of the cleaning gas to be introduced into the polymer film device 40, the separator 44 and the reaction chamber 12 are controlled by a control device which is not shown. Consequently, the gas component is caused to be constant. For example, the concentration of COF₂ is monitored to bring the cleaning gas component in the reaction chamber 12 into a constant stationary state also when the reaction chamber recycling path 32 is opened.

Moreover, a safety valve 50 constituting a pressure releasing device is formed on the exhaust gas recycling path 36. This safety valve 50 has such a structure that a pressure is released by the control of the control device (not shown) when the exhaust gas recycling path 36 has a certain pressure of 0.5 MPa or more, for example. The safety valve 50 may be constituted by a relief valve for automatically opening when a certain pressure is obtained without depending on the control of the control device.

Furthermore, the exhaust gas recycling path 36 is provided with the reaction chamber recycling path 32 which is branched from the exhaust gas recycling path 36 and is served to recycle the exhaust gas to the reaction chamber 12.

In the drawing, 52, 54, 56, 58, 60 and 62 denote a switching valve.

The CVD apparatus 10 according to the present invention having such a structure is operated in the following manner.

First of all, the base material A for depositing a silicon thin film on a surface of a silicon wafer or the like, for example, is mounted over the stage of the lower electrode 18 in the reaction chamber 12. Thereafter, a distance between the base material A and the upper electrode 20 is regulated to be a predetermined distance by a driving mechanism which is not shown.

An internal gas is discharged to the outside through the exhaust path 16 formed on the bottom wall 12c in the reaction chamber 12, by means of the dry pump 14. Consequently, a constant vacuum state (a decompression state), for example, a decompression state of 10 to 2000 Pa is maintained.

The switching valve 52 provided on the reactive gas supply path 26 is opened and a film forming gas is introduced from the film forming gas supply source 28 into the reaction chamber 12, which is maintained in the decompression state, through the reactive gas supply path 26 and the upper' electrode 20.

At this time, the switching valve 52 provided on the reactive gas supply path 26 and the switching valve 54 provided on the exhaust path 16 are opened. On the other hand, the switching valve 56 provided on the cleaning gas supply path 30, the switching valves 58 and 62 provided on the exhaust gas recycling path 36, and the switching valve 60 provided on the reaction chamber recycling path 32 are closed.

In this case, it is preferable that monosilane (SiH₄), N₂O, N₂, O₂, Ar and the like in the formation of the film of silicon oxide (SiO₂) and the monosilane (SiH₄), NH₃, N₂, O₂ and Ar in the formation of the film of silicon nitride (Si₃N₄ or the like) should be supplied as the film forming gas which is to be fed from the film forming gas supply source 28, for example. However, the film forming gas is not restricted to them and they can properly be changed, for example, disilane (Si₂H₆), TEOS (tetraethoxysilane ; Si(OC₂H₅)₄) or the like is used as the film forming gas and O₂, O₃ or the like is used as a carrier gas depending on the type of a thin film to be formed, for example.

A high frequency electric field is generated from the high frequency applicator 25 such as a high frequency application coil to the upper electrode 20 by a high frequency generated from the high frequency power source 24. Then, electrons are impacted with neutral molecules of the film forming gas in the electric field. As a result, a high frequency plasma is formed and the film forming gas is dissociated into ions and radicals. By the actions of the ions and radicals, a silicon thin film is formed on the surface of the base material A such as a silicon wafer which is provided on the lower electrode 18.

In such a CVD apparatus 10, at a film forming step, a thin film material such as SiO₂ or Si₃N₄ is also adhered to and deposited on the surfaces of an inner wall, an electrode and the like in the reaction chamber 12 other than a semiconductor product A to be formed. As a result, a by-product is formed by a discharge in the reaction chamber 12. When this by-product grows to have a constant thickness, it is peeled and scattered by a dead weight, a stress or the like. At the film forming step, consequently, fine particles to be foreign matters are mixed into the semiconductor product so that contamination is caused. For this reason, a thin film of high quality cannot be manufactured so that the disconnection or short-circuit of a semiconductor circuit is caused. In addition, there is a possibility that a yield or the like might also be deteriorated.

Moreover, the by-product supplied from the reaction chamber 12 is also adhered to the side wall of the piping of the exhaust path 16 or the like. Consequently, the exhaust path 16 is narrowed. In some cases, therefore, a film forming efficiency and a gas utilization efficiency are reduced.

In the CVD apparatus 10 according to the present invention, therefore, a fluorinated cleaning gas containing a fluorocompound, that is, a cleaning gas supplied from the cleaning gas source 34 is introduced into the reaction chamber 12 through the cleaning gas supply path 30.

More specifically, after the thin film processing is ended as described above, the switching valve 52 provided on the reactive gas supply path 26 is closed to stop the supply of the film forming gas from the film forming gas supply source 28 into the reaction chamber 12.

Then, the switching valve 56 provided on the cleaning gas supply path 30 is opened to introduce the cleaning gas from the cleaning gas source 34 into the reaction chamber 12. through the cleaning gas supply path 30.

The high frequency is generated through the high frequency power source 24, and thereafter, a high frequency electric field is generated from the high frequency applicator 25 such as a high frequency application coil to the upper electrode 20, so that a high frequency plasma is formed. As a result, the cleaning gas is dissociated into ions and radicals, and the ions and the radicals react to a by-product such as SiO₂ or Si₃N₄ which is adhered to and deposited on the surfaces of the inner wall, the electrode and the like in the reaction chamber 12 so that the by-product is changed into a gas as SiF₄.

At this time, the switching valve 54 provided on the exhaust path 16 is closed, and the switching valves 58 and 62 provided on the exhaust gas recycling path 36 and the switching valve 60 provided on the reaction chamber recycling path 32 are opened so that the exhaust gas recycling path 36 and the reaction chamber recycling path 32 are opened.

In this case, the switching valve 54 does not need to be fully closed but a part of the exhaust gas may be caused to flow to the toxicity removing device 13 in the exhaust path 16.

Consequently, the exhaust gas obtained after the execution of the cleaning process in the reaction chamber 12 flows through the exhaust gas recycling path 36, and is converted to a plasma by the plasma generating device 33 and is then recycled to the upstream side of the exhaust path 16.

Moreover, the exhaust gas obtained after the execution of the cleaning process in the reaction chamber 12 flows from the exhaust gas recycling path 36 to the reaction chamber recycling path 32, and then reaches the reactive gas supply path 26 and is recycled to the reaction chamber 12.

For example, the exhaust gas obtained after the execution of the cleaning process in the reaction chamber 12 contains a gas component such as COF₂, CF₄, C₂F₆, F₂, SiF₄, CO, CO₂, HF, N₂ or O₂.

The exhaust gas flowing through the exhaust gas recycling path 36 absorbs and removes an inactive gas such as N₂ or O₂ in the exhaust gas by the polymer film device 40. The inactive gas thus absorbed and removed by the polymer film device 40 can also be recovered and recycled through a recovery path (not shown) separately.

The pressure of the exhaust gas, from which the inactive gas in the exhaust gas is removed by the polymer film device 40, is raised through the compressor 42 if necessary. Thereafter, the exhaust gas is introduced into the separator 44 when the separator 44 is required. In this case, it is desirable that the pressure should be raised to 0.01 to 0.5 MPa by the compressor 42 in order to prevent the clogging of the separator 44 and the generation of particles.

In the case in which the separator 44 is thus provided, the unnecessary exhaust gas component such as SiF₄, HF, CO or CO₂ can selectively be removed from the exhaust gas. In this case, although not shown, the unnecessary exhaust gas component removed through the separator 44 may be properly discarded through the toxicity removing device for making non-toxicity or may be appropriately separated and recycled.

Accordingly, the exhaust gas passing through the separator 44 contains, as a cleaning gas component, a cleaning gas component such as COF₂, CF₄, C₂F₆ or F₂ or a concentrated gas. The exhaust gas is converted to a plasma by the plasma generating device 33 through the exhaust gas recycling path 36 and is then recycled to the upstream side of the exhaust path 16. Consequently, the side wall of the piping of the exhaust path 16 or the like can be cleaned and the exhaust path 16 can be prevented from being closed. Thus, it is possible to enhance a film forming efficiency and a gas utilization efficiency.

Moreover, the exhaust gas which passes through the separator 44 and reaches the reactive gas supply path 26 through the reaction chamber recycling path 32, and is recycled to the reaction chamber 12 contains, as a cleaning gas component, a cleaning gas component such as COF₂, CF₄, C₂F₆ or F₂ or a concentrated gas component, and the cleaning can be thus carried out. Therefore, the gas utilization efficiency can be enhanced. In this case, the gas utilization efficiency implies a ratio (%) indicating that the supplied cleaning gas is replaced by a recycle gas.

In this case, both the recycling of the exhaust gas (the cleaning gas) to the upstream side of the exhaust path 16 through the exhaust gas recycling path 36 and the plasma generating device 33 and the recycling of the exhaust gas (the cleaning gas) to the reaction chamber 12 through the reaction chamber recycling path 32 may be carried out at the same time or one of them may be carried out. Such a control is preferably performed by controlling the switching valves 58 and 62 provided on the exhaust gas recycling path 36 and the switching valve 60 provided on the reaction chamber recycling path 32 based on a program in a control device in advance.

In this case, as described above, the gas analyzing sensor 46 is provided on the exhaust gas recycling path 36 as described above. Consequently, the component of the exhaust gas in the exhaust gas recycling path 36 and the reaction chamber recycling path 32, which is recycled in the reaction chamber 12, is detected and the amounts of the cleaning gas to be introduced into the polymer film device 40, the separator 44 and the reaction chamber 12 are controlled by the controller. Consequently, the gas component is caused to be constant.

More specifically, for example, the concentration of COF₂ is monitored to bring the cleaning gas component in the reaction chamber 12 into a constant stationary state. Thus, it is possible to execute uniform and efficient cleaning.

In such a stationary state, it is preferable that the concentration of COF₂ should be set within a range of 50% or more, and preferably 70 to 80%, for example, in consideration of the gas utilization efficiency.

As described above, moreover, the safety valve 50 constituting the pressure releasing device is formed on the exhaust gas recycling path 36, and the exhaust gas recycling path 36 is constituted to release a pressure by the control of the control device when a certain pressure or more is obtained.

By such a structure, the pressure is released by the pressure releasing device when a certain pressure or more is obtained in the exhaust gas recycling path 36. Consequently, it is possible to prevent a rise in the pressure of the exhaust gas recycling path 36 which breaks and damages apparatuses such as the piping of the exhaust gas recycling path 36, the pump, the polymer film device and the separator. The safety valve 50 is controlled to be operated also when the pressure of the exhaust gas staying in the exhaust gas recycling path 36 is raised at the film forming step as described above.

Thus, the cleaning process is carried out while the exhaust gas is recycled into the reaction chamber 12 through the exhaust gas recycling path 36, and furthermore, the exhaust gas flowing through the exhaust gas recycling path 36 is converted to a plasma by the plasma generating device 33, and is then recycled to the upstream side of the exhaust path 16. Consequently, the side wall in the piping of the exhaust path 16 or the like is cleaned.

After the cleaning process is ended, then, the switching valve 56 provided on the cleaning gas supply path 30 is closed to stop the supply of the cleaning gas from the cleaning gas source 34.

Moreover, the switching valves 58 and 62 provided on the exhaust gas recycling path 36, and the switching valve 60 provided on the reaction chamber recycling path 32 are closed, and the exhaust gas recycling path 36 and the reaction chamber recycling path 32 are thus closed. Then, the switching valve 54 provided on the exhaust path 16 is opened and the switching valve 52 provided on the reactive gas supply path 26 is opened so that the supply of the film forming gas from the film forming gas supply source 28 into the reaction chamber 12 is started. As a result, a film forming process cycle is again started.

In this case, during the cleaning, a control may be carried out by the control device in such a manner that the reactive gas supply path 26 is opened and the exhaust gas recycling path 36 and the reaction chamber recycling path 32 are opened if necessary in the initial stage of the cleaning, and the reactive gas supply path 26 is closed to carry out the cleaning after the cleaning proceeds.

By such a structure, for example, C₂F₆ to be the cleaning gas is caused to flow for a constant time and COF₂ is then generated. Therefore, it is possible to use the COF₂ as the cleaning gas by recycling the COF₂ through the reaction chamber recycling path 32 and the exhaust gas recycling path 36. Consequently, the utilization efficiency of the cleaning gas can be enhanced and a cost can also be reduced.

In this case, examples of a fluorinated cleaning gas containing a fluorocompound to be used for a cleaning process include perfluorocarbons having the number of carbon atoms of 1 to 6, for example:
chain aliphatic perfluorocarbons such as CF₄, C₂F₆, C₃F₈, C₄F₁₀ and C₅F₁₂;
alicyclic perfluorocarbons such as C₄F₈, C₅F₁₀ and C₆F₁₂;
linear perfluoroethers such as CF₃OCF₃, CF₃OC₂F₅ and C₂F₅OC₂F₅;
cyclic perfluoroethers such as C₃F₆O, C₄F₈O and C₅F₁₀O;
unsaturated perfluorocarbons such as C₃F₆, C₄F₈ and C₅F₁₀; and
diene perfluorocarbons such as C₄F₆ and C₅F₈.

Moreover, it is also possible to use perfluorocarbons containing oxygen such as COF₂, CF₃COF or CF₃OF, fluorocompounds containing nitrogen such as NF₃, FNO, F₃NO or FNO₂, and preferably, a fluorocompound containing oxygen and nitrogen.

These fluorocompounds may contain at least one fluorine atom having a part thereof replaced with a hydrogen atom.

It is preferable to use CF₄, C₂F₆ and C₃F₈ and more preferable to use CF₄ and C₂F₆.

These fluorocompounds can be used singly or in combination.

Moreover, the cleaning gas containing the fluorocompound used in the present invention can be utilized by properly mixing another gas within such a range that the advantage of the present invention is not damaged. Examples of another gas include He, Ne, Ar, O₂ and the like. The amount of blending of the gas is not particularly restricted but can be determined corresponding to the amount and thickness of a by-product (an adherend) adhered to the inner wall of the reaction chamber 12 in the CVD apparatus 10 or the like, the type of the fluorocompound to be used, the composition of the by-product and the like.

In addition, it is possible to utilize a fluorine gas (F₂) as a cleaning gas to be used for the cleaning process in addition to the fluorinated cleaning gases containing the fluorocompounds described above.

More specifically, a proper amount of additive gas such as oxygen or argon is usually mixed with the cleaning gas and is thus used in plasma cleaning.

In a mixed gas type of the cleaning gas and the additive gas, an etching speed tends to be increased when a content concentration of the cleaning gas is increased on condition that a total gas flow is constant. If the cleaning gas exceeds a constant concentration, however, there is a problem in that the generation of a plasma becomes unstable and the etching speed slows down and is deteriorated, and a cleaning uniformity is deteriorated. In particular, if the cleaning gas is used in a concentration of 100%, there is a problem in that the instability of the generation of the plasma, the slow-down and deterioration of the etching speed, and the deterioration in the cleaning uniformity tend to be more remarkable, and practical use is incomplete.

For this reason, it is necessary to carry out a dilution in order to reduce the concentration of a cleaning gas down to the concentration of a peak of an etching speed - cleaning gas concentration curve or to a low concentration which is equal to or less than the concentration. A chamber pressure in the cleaning is raised or a gas flow is increased in order to suppress a reduction in the etching speed with the dilution, thereby optimizing the cleaning conditions. If the chamber pressure in the cleaning is raised or the gas flow is increased, however, the generation of the plasma is not stabilized so that the cleaning uniformity is damaged and the cleaning cannot be efficiently carried out.

On the other hand, by using, as the cleaning gas, a fluorine gas or a mixed gas of the fluorine gas and a gas which does not substantially react to fluorine in a plasma, it is possible to carry out a plasma processing. Consequently, an extremely excellent etching speed can be obtained. In addition, the plasma can be stably generated and an excellent cleaning uniformity can be maintained on condition that a total gas flow is approximately 1000 sccm and a chamber pressure is approximately 400 Pa.

If such a fluorine gas is used, moreover, an exhaust gas obtained after the execution of the cleaning process in the reaction chamber 12 contains HF, SiF₄ and the like in addition to unreacted F₂. Even if the separator 44 is not operated, accordingly, it is possible to utilize the exhaust gas as the cleaning gas again by simply operating the polymer film device 40 to absorb and remove an inactive gas such as N₂ or O₂ which is contained in the exhaust gas of the exhaust gas recycling path 36, for example. Therefore, it is possible to execute cleaning which is more uniform and efficient.

In this case, the switching valve 54 is not fully closed but causes a part of the exhaust gas to flow toward the toxicity removing device 13, thereby controlling the excessive storage of HF and SiF₄.

It is desirable that a fluorine gas to be used as the cleaning gas should be a fluorine gas of 100 % by volume and should generate a plasma by a discharge.

Moreover, the gas for the cleaning may be constituted by a fluorine gas generating a plasma by a discharge and a gas which does not substantially react to fluorine in the plasma.

In this case, it is preferable that the concentration of the fluorine gas generating a plasma by a discharge should be set within a range of 20% by volume to 100% by volume and the concentration of a gas which does not substantially react to fluorine in the plasma should be set within a range of 0% by volume to 80% by volume (a fluorine gas generating a plasma by a discharge + a gas which does not substantially react to fluorine = 100% by volume).

In addition, it is more preferable that the concentration of the fluorine gas generating the plasma by the discharge should be set within a range of 30% by volume to 100% by volume and the concentration of a gas which does not substantially react to fluorine in the plasma should be set within a range of 0% by volume to 70% by volume (a fluorine gas generating a plasma by a discharge + a gas which does not substantially react to fluorine = 100% by volume).

Furthermore, it is preferable that a gas which does not substantially react to fluorine in a plasma should be at least one selected from a group including nitrogen, oxygen, carbon dioxide, N₂O, dry air, argon, helium and neon.

In this case, the "fluorine" in the gas which does not substantially react to fluorine includes a fluorine molecule, a fluorine atom, a fluorine radical, a fluorine ion and the like.

Examples of the desired compound for chamber cleaning based on the fluorocompound include an adherend comprising a silicon compound which is adhered to a CVD chamber wall, a jig of a CVD apparatus and the like by a CVD method or the like. Examples of the adherend of such a silicon compound include at least one of:
(1) a compound comprising silicon,
(2) a compound comprising at least one of oxygen, nitrogen, fluorine and carbon, and silicon, or
(3) a compound comprising a high-melting-point metal silicide. More specifically, for example, it is possible to use a high-melting-point metal silicide such as Si, SiO₂, Si₃N₄ or WSi.

Moreover, it is desirable that the flow of the cleaning gas to be introduced into the reaction chamber 12 should be 0.1 to 10 L/min and preferably 0.5 to 1. L/min in consideration of the effect obtained by cleaning a by-product adhered to the inner wall of the chamber 12. More specifically, if the flow of the cleaning gas to be introduced into the reaction chamber 12 is less than 0.1 L/min, the cleaning effect cannot be expected. To the contrary, if the flow of the introduction is more than 10 L/min, the amount of the cleaning gas to be discharged to the outside without contributing to the cleaning is increased.

The flow of the introduction can be properly changed depending on the type, size or the like of the base material A, for example, a flat panel disc. As an example, it is preferable that the flow of the introduction should be set to be 0.5 to 5 L/min if the fluorocompound is C₂F₆.

In consideration of the effect obtained by cleaning the by-product adhered to the inner wall of the chamber 12, furthermore, it is desirable that the pressure of the cleaning gas in the reaction chamber 12 should be 10 to 2000 Pa and preferably 50 to 500 Pa. More specifically, if the pressure of the cleaning gas in the reaction chamber 12 is smaller than 10 Pa or is more than 2000 Pa, the cleaning effect cannot be expected. The pressure in the reaction chamber 12 can be properly changed depending on the type, size or the like of the base material A such as a flat panel disc. As an example, it is preferable that the pressure should be 100 to 500 Pa if the fluorocompound is C₂F₆.

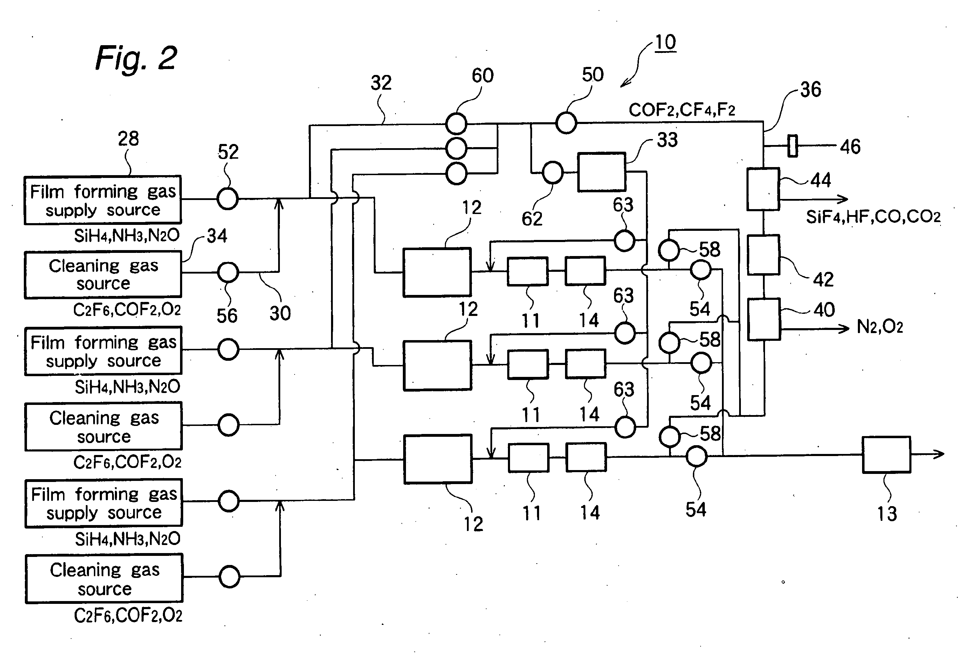

Fig. 2 is a schematic view showing a second embodiment of the CVD apparatus 10 according to the present invention.

The CVD apparatus 10 according to the present embodiment has basically the same structure as that of the CVD apparatus 10 shown in Fig. 1, and the same components have the same reference numerals and detailed description thereof will be omitted. In Fig. 2, 63 denotes a switching valve provided on each exhaust gas recycling path 36.

While the reaction chamber 12 is set to be a single reaction chamber in the CVD apparatus 10 according to the embodiment in Fig. 1, the CVD apparatus 10 according to the present embodiment is of a so-called multichamber type in which a plurality of reaction chambers 12 are connected in parallel as shown in Fig. 2. Consequently, a film forming efficiency and a gas utilization efficiency can be more enhanced.

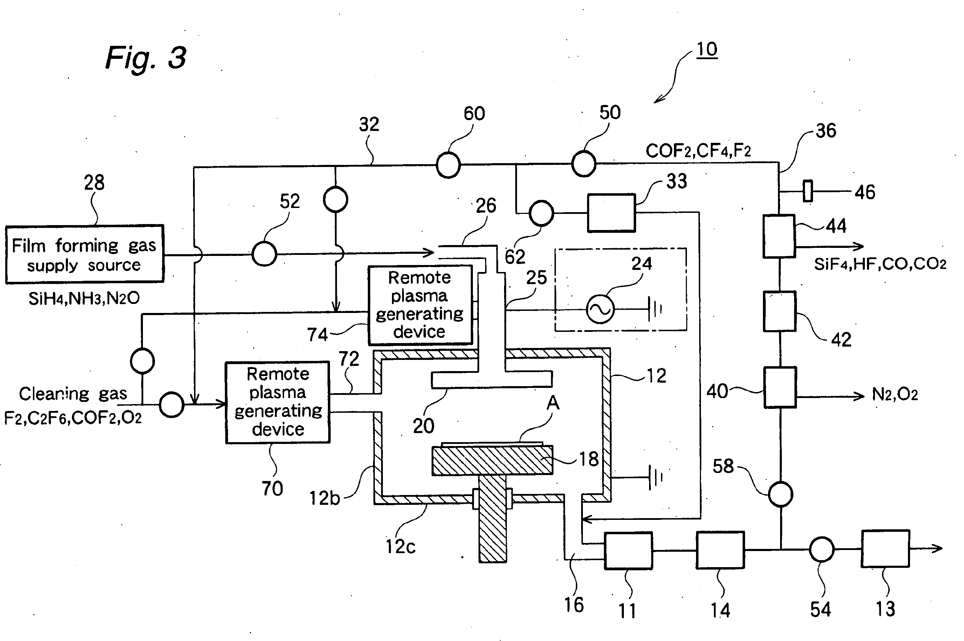

Fig. 3 is a schematic view showing a third embodiment of the CVD apparatus 10 according to the present invention.

The CVD apparatus 10 according to the present embodiment has basically the same structure as that of the CVD apparatus 10 shown in Fig. 1, and the same components have the same reference numerals and detailed description thereof will be omitted.

The CVD apparatus 10 according to the embodiment in Fig. 1 is constituted to introduce the cleaning gas supplied from the cleaning gas source 34 into the reaction chamber 12 through the cleaning gas supply path 30. On the contrary, a fluorinated cleaning gas containing a fluorocompound is converted to a plasma by a remote plasma generating device 70 and the plasma is introduced from a side wall 12b of the reaction chamber 12 maintained in a decompression state into the reaction chamber 12 through a connecting piping 72 in the CVD apparatus 10 according to the present embodiment as shown in Fig. 3.

In this case, the material of the connecting piping 72 is not particularly restricted but it is desirable to use alumina, inactivated aluminum, a fluororesin and a metal coated with a fluororesin, for example, in consideration of the effect of preventing the reduction in a gasification efficiency.

The remote plasma generating device 70 and the reaction chamber 12 are so arranged that a cleaning gas converted to a plasma is introduced from the chamber side wall 12b through the connecting piping 72 in the present embodiment. However, it is not restricted but it is sufficient that the cleaning gas is directly introduced into the reaction chamber 12. More specifically, the cleaning gas may be introduced from the top wall 12a and the bottom wall 12c in the chamber 12, for example.

As shown in Fig. 3, furthermore, the cleaning gas can be passed through a remote plasma generating device 74 and the cleaning gas converted to a plasma can also be introduced into the reaction chamber 12 through the shower head of the upper electrode 20 in the upper part of the reaction chamber 12.

As shown in Fig. 3, it is desirable that the cleaning gas recycled by the exhaust gas recycling path 36 should be returned to the forward part of the remote plasma generating device 70 or the remote plasma generating device 74 and the cleaning gas should be converted to a plasma by the remote plasma generating device 70 or the remote plasma generating device 74 and should be introduced into the reaction chamber 12 from the chamber side wall 12b of the reaction chamber 12 or through the shower head of the upper electrode 20 in the upper part of the reaction chamber 12.

In this case, in the initial stage of the cleaning during the cleaning, it is also possible to carry out a control by means of a control device so as to open a cleaning gas supply path (the connecting piping 72) from the remote plasma generating device 70 or 74, to open the exhaust gas recycling path 36 and the reaction chamber recycling path 32 if necessary, and to close the cleaning gas supply path after the progress of the cleaning, thereby performing the cleaning.

By such a structure, after C₂F₆ to be the cleaning gas is caused to flow for a constant time, for example, COF₂ is generated. Therefore, the COF₂ is recycled by means of the exhaust gas recycling path and can be thus used as the cleaning gas. Consequently, the utilization efficiency of the cleaning gas can be enhanced and a cost can also be reduced.

Furthermore, a well-known remote plasma generating device is preferably used as the remote plasma generating device 70 and is not particularly restricted. For example, "ASTRON" (manufactured by ASTEX Co., Ltd.) can be used.

After a film forming process is thus carried out, the fluorinated cleaning gas containing a fluorocompound is converted to a plasma by the remote plasma generating device 70 and the cleaning gas thus converted to the plasma is introduced into the reaction chamber 12, and a by-product adhered into the reaction chamber 12 is removed. By such a structure, it is possible to enhance the dissociation efficiency of the cleaning gas and to efficiently remove a by-product such as SiO₂ or Si₃N₄ which is adhered to and deposited on the surfaces of an inner wall, an electrode and the like in the reaction chamber 12. In addition, the amount of the cleaning gas to be discharged is extremely small and the influence on an environment such as global warming can also be lessened, and the cost can also be reduced.

While the examples of the cleaning device in the plasma CVD apparatus according to the present invention have been described above, the formation of a silicon thin film has been described in the above examples. Without departing from the scope of the present invention, for example, the examples can also be applied to the case in which a thin film such as another silicon germanium film (SiGe) , a silicon carbide film (SiC), an SiOF film, an SiON film or a carbonaceous SiO₂ film is formed.

Although the horizontal apparatus has been described in the examples, it is also possible to use a vertical apparatus in place thereof. While the leaf type has been described in the examples, moreover, the present invention can also be applied to a batch type CVD apparatus.

While the exhaust gas (the cleaning gas) flowing through the exhaust gas recycling path 36 is converted to a plasma by the plasma generating device 33 and is then recycled to the upstream side of the exhaust path 16, thereby cleaning the side wall in the piping of the exhaust path 16 or the like in the examples, moreover, the invention can also be used for a portion other than the piping of the exhaust path 16 or the like.

Although the present invention has been applied to the plasma CVD apparatus in the examples, for instance, it is a matter of course that various changes can be made, that is, the present invention can also be applied to other CVD methods such as a vacuum deposition method in which a thin film material is deposited on a substrate by thermal decomposition, oxidation, reduction, polymerization, vaporization reaction or the like at a high temperature.

According to the present invention, the inner part of the reaction chamber can be cleaned, and furthermore, a by-'product such as SiO₂ or Si₃N₄ adhered to the piping of the exhaust path, the exhaust gas recycling path or the like can be cleaned while the exhaust gas converted to a plasma by the plasma generating device is recycled to the upstream side of the exhaust path through the exhaust gas recycling path. Consequently, the piping can be prevented from being closed. Thus, it is possible to enhance a film forming efficiency and a gas utilization efficiency.

According to the present invention, moreover, the inner part of the reaction chamber is cleaned while the exhaust gas is recycled to the reaction chamber through the exhaust gas recycling path and the reaction chamber recycling path. Therefore, a cleaning gas component contained in the exhaust gas can be used again as a cleaning gas in the reaction chamber. Consequently, the gas utilization efficiency can be enhanced.

Accordingly, a by-product such as SiO₂ or Si₃N₄ adhered to and deposited on the piping of the exhaust path, the exhaust gas recycling path or the like and the inner part of the reaction chamber can be removed. In film formation, therefore, the mixture of fine particles into a semiconductor product and contamination thereof can be eliminated, a thin film of high quality can be manufactured and a yield or the like can also be enhanced.

Moreover, the cleaning gas component discharged finally to the outside is very lessened. Therefore, the amount of the discharge of the cleaning gas is also very small and an influence on an environment such as global warming can also be lessened.

According to the present invention, furthermore, the exhaust gas is recycled from the downstream side of the dry pump to the upstream side of the exhaust path. Therefore, a pressure is raised and the generation of particles is eliminated, and the clogging of a filter is lessened and the particles are not recycled into the reaction chamber. Consequently, a cleaning effect can be enhanced.

According to the present invention, moreover, an inactive gas such as N₂ or O₂ can be absorbed and removed by the polymer film device, for example. Therefore, it is possible to clean the piping of the exhaust path, the exhaust gas recycling path or the like by recycling only the cleaning gas component to the upstream side of the exhaust path. Consequently, the gas utilization efficiency can be enhanced. Moreover, it is possible to recover and recycle the inactive gas thus absorbed and removed.

According to the present invention, furthermore, an unnecessary exhaust gas component such as SiF₄, HF, CO or CO₂ is selectively removed by the separator. For example, therefore, it is possible to clean the piping of the exhaust path, the exhaust gas recycling path or the like by recycling a cleaning gas component such as COF₂, CF₄ or F₂ or a concentrated gas component to the upstream side of the exhaust path. Consequently, the gas utilization efficiency can be enhanced.

According to the present invention, moreover, the pressure of the exhaust gas, that is, the cleaning gas is raised by means of the compressor and the same gas is recycled to the upstream side of the exhaust path. Therefore, a pressure in the piping of the exhaust path, the exhaust gas recycling path or the like can be held to be constant. Consequently, it is possible to maintain the cleaning effect to be constant.

According to the present invention, furthermore, the concentration of COF₂ flowing in the exhaust gas recycling path is monitored by the control device, for example. Consequently, the cleaning gas component in the piping of the exhaust path, the exhaust gas recycling path or the like can be maintained in a constant stationary state. Therefore, it is possible to execute uniform and efficient cleaning.

According to the present invention, moreover, the pressure is released by the pressure releasing device when the pressure of the exhaust gas recycling path is a constant pressure or more. Therefore, it is possible to prevent a rise in the pressure of the exhaust gas recycling path which causes the breakage and damage of apparatuses such as the piping of the exhaust path or the exhaust gas recycling path, the pump, the polymer film device and the separator.

According to the present invention, furthermore, the exhaust gas recycling path is opened in the cleaning. Therefore, the inner part of the piping of the exhaust path or the exhaust gas recycling path is cleaned while the exhaust gas is recycled to the upstream side of the exhaust path through the exhaust gas recycling path. Consequently, it is possible to use the cleaning gas component contained in the exhaust gas as a cleaning gas for cleaning the inner part of the piping of the exhaust path or the exhaust gas recycling path again. Consequently, the gas utilization efficiency can be enhanced.

On the other hand, when a deposited film is to be formed on the surface of the base material in the reaction chamber, the exhaust gas recycling path is closed. Consequently, it is possible to hold a film forming gas component to be constant. Thus, it is possible to form a uniform thin film of constant quality on the base material.

According to the present invention, moreover, after the cleaning gas, for example, C₂F₆ is caused to flow for a constant time, COF₂ is generated. Therefore, the COF₂ is recycled through the exhaust gas recycling path and the reaction chamber recycling path and can be thus used as the cleaning gas. Consequently, the utilization efficiency of the cleaning gas can be enhanced and a cost can also be reduced. Thus, the present invention is very excellent and can produce various remarkable and special functions and effects.

## Claims

1. A CVD apparatus (10) for supplying a reactive gas into a reaction chamber (12) and forming a deposited film on a surface of a base material (A) provided in the reaction chamber,
wherein an exhaust path (16) for exhausting a gas through a dry pump (14) and a toxicity removing device (13) from an inner part of the reaction chamber is provided with an exhaust gas recycling path (36) for recycling the exhaust gas, which is branched from a downstream side of the dry pump and an upstream side of the toxicity removing device to an upstream side of the dry pump on the exhaust path,
a plasma generating device (33) is provided on the exhaust gas recycling path, and
the exhaust gas recycling path is provided with a reaction chamber recycling path (32) for recycling the exhaust gas to the reaction chamber.

2. The CVD apparatus (10) according to claim 1, wherein a separator (44) for selectively removing an unnecessary exhaust gas component is provided on the exhaust gas recycling path (36).

3. The CVD apparatus (10) according to claim 1 or 2, wherein the exhaust gas recycling path (36) is provided with a compressor (42) for raising a pressure of an exhaust gas and recycling the exhaust gas to the upstream side of the exhaust path.

4. The CVD apparatus (10) according to any of claims 1 to 3, wherein the exhaust gas recycling path (36) is provided with a control device for detecting a component of the exhaust gas recycled to the upstream side of the exhaust path and causing the gas component to be constant.

5. The CVD apparatus (10) according to any of claims 1 to 4, wherein the exhaust gas recycling path (36) is provided with a pressure releasing device for releasing a pressure when the exhaust gas recycling path has a constant pressure or more.

6. The CVD apparatus (10) according to any of claims 1 to 5, further comprising a switching device (58, 62) for switching the exhaust gas recycling path (36) and a reactive gas supply path (26), wherein the switching device is arranged to carry out a switching control such that the exhaust gas recycling path is opened when a cleaning gas is to be introduced through the reactive gas supply path into the reaction chamber (12), the inner part of which is thereby cleaned, and the switching device is arranged to carry out a switching control to close the exhaust gas recycling path when a deposited film is to be formed on a surface of a base material (A) in the reaction chamber.

7. The CVD apparatus (10) according to any of claims 1 to 5, further comprising a switching device (58, 62) for switching the exhaust gas recycling path (36) and a reactive gas supply path (26), wherein the switching device is arranged to carry out a switching control such that the exhaust gas recycling path is opened when a cleaning gas is to be introduced through a remote plasma generating device (70, 74) into the reaction chamber (12), the inner part of which is thereby cleaned, and the switching device is arranged to carry out a switching control to close the exhaust gas recycling path when a deposited film is to be formed on the surface of the base material (A) in the reaction chamber.

8. The CVD apparatus (10) according to any preceding claim, wherein the switching device (52, 58, 60, 62) is arranged to carry out a switching control such that the reactive gas supply path (26) is opened and the exhaust gas recycling path (36) and the reaction chamber recycling path (32) are opened if necessary in an initial stage of the cleaning,
and wherein the switching device is arranged to carry out a switching control to close the reactive gas supply path for carrying out the cleaning after progress of the cleaning.

9. The CVD apparatus (10) according to any of claims 1 to 7, wherein the switching device (56, 58, 60, 62) is arranged to carry out a switching control such that a cleaning gas supply path (30) from a remote plasma generating device (70, 74) is opened and the exhaust gas recycling path (36) and the reaction chamber recycling path (32) are opened if necessary in an initial stage of the cleaning, and wherein the switching device is arranged to carry out a switching control to close the cleaning gas supply path for carrying out the cleaning, after progress of the cleaning.

10. The CVD apparatus (10) according to any preceding claim, wherein a cleaning gas used for removing a by-product adhered into the reaction chamber (12) after a film forming process for a substrate is carried out by the CVD apparatus is a cleaning gas containing a fluorine gas.

11. A method of cleaning a CVD apparatus (10) in which a reactive gas is supplied into a reaction chamber (12) through a reactive gas supply path (26) and a deposited film is formed on a surface of a base material (A) provided in the reaction chamber, and an inner part of the reaction chamber is then cleaned,
wherein an exhaust gas is converted to a plasma and the exhaust gas is recycled to an upstream side of a dry pump (14) on an exhaust path (16) through an exhaust gas recycling path (36), which is branched from a downstream side of the dry pump and an upstream side of a toxicity removing device (13) on the exhaust path for exhausting a gas from the inner part of the reaction chamber, through the dry pump and the toxicity removing device, so that an inner part of a piping is cleaned,
a reaction chamber recycling path (32) for recycling the exhaust gas to the reaction chamber is provided on the exhaust gas recycling path, and
the inner part of the reaction chamber is cleaned through the reaction chamber recycling path.

12. The method of cleaning a CVD apparatus (10) according to claim 11, wherein a polymer film device (40) for absorbing and removing an inactive gas in the exhaust gas is provided on the exhaust gas recycling path (36).

13. The method of cleaning a CVD apparatus (10) according to claim 11 or 12, wherein a separator (44) for selectively removing an unnecessary exhaust gas component is provided on the exhaust gas recycling path (36).

14. The method of cleaning a CVD apparatus (10) according to any of claims 11 to 13, wherein the exhaust gas recycling path (36) is provided with a compressor (42) for raising a pressure of the exhaust gas and recycling the exhaust gas to the upstream side of the exhaust path (16).

15. The method of cleaning a CVD apparatus (10) according to any of claims 11 to 14, wherein the exhaust gas recycling path (36) is provided with a control device for detecting a component of the exhaust gas recycled to the upstream side of the exhaust path (16) and causing the gas component to be constant.

16. The method of cleaning a CVD apparatus (10) according to any of claims 11 to 15, wherein the exhaust gas recycling path (36) is provided with a pressure releasing device (50) for releasing a pressure when the exhaust gas recycling path has a constant pressure or more.

17. The method of cleaning a CVD apparatus (10) according to any of claims 11 to 16, wherein the reactive gas supply path (26) is opened and the exhaust gas recycling path (36) and the reaction chamber recycling path (32) are opened if necessary in an initial stage of the cleaning during the cleaning, and
the reactive gas supply path is closed to carry out the cleaning after the cleaning progresses.

18. The method of cleaning a CVD apparatus (10) according to any of claims 11 to 16, wherein when a cleaning gas is to be introduced into the reaction chamber (12) through a remote plasma generating device (70, 74), thereby cleaning an inner part of the reaction chamber, a cleaning gas supply path (30) from the remote plasma generating device is opened and the exhaust gas recycling path (36) and the reaction chamber recycling path (32) are opened if necessary in an initial stage of the cleaning, and
the reactive gas supply path (26) is closed to carry out the cleaning after the cleaning progresses.

19. The method of cleaning a CVD apparatus (10) according to any of claims 11 to 18, wherein after a film forming process for a substrate is carried out by the CVD apparatus, a cleaning gas to be used for removing a by-product adhered into the reaction chamber (12) is a cleaning gas containing a fluorine gas.

## Patentansprüche

1. CVD-Vorrichtung (10) zum Zuführen eines Reaktivgases bzw. Reaktionsgases in eine Reaktionskammer (12) und Bilden eines aufgebrachten bzw. abgeschiedenen Films auf einer Oberfläche eines Basismaterials (A), das in der Reaktionskammer bereitgestellt wird,
wobei ein Abgaskanal (16) zum Absaugen eines Gases durch eine Trockenpumpe (14) und eine Toxizitätsentfernungsvorrichtung (13) von einem inneren Bereich der Reaktionskammer mit einem Abgas-Rückführungskanal (36) zur Wiedergewinnung bzw. Rückführung des Abgases bereitgestellt ist, der aus einer Abstromseite bzw. stromabwärtigen Seite der Trockenpumpe und aus einer Stromaufseite bzw. stromaufwärtigen Seite der Toxizitätsentfernungsvorrichtung zu einer Stromaufseite der Trockenpumpe auf dem Abgaskanal verzweigt ist bzw. wird,
eine Plasmaerzeugungsvorrichtung (33) auf dem Abgas-Rückführungskanal bereitgestellt ist, und
der Abgas-Rückführungskanal mit einem Reaktionskammer-Rückführungskanal (32) zur Rückgewinnung bzw. zur Rückführung des Abgases in die Reaktionskammer bereitgestellt ist.

2. CVD-Vorrichtung (10) nach Anspruch 1, wobei ein Separator (44) zum wahlweisen Entfernen einer unnötigen Abgaskomponente auf dem Abgas-Rückführungskanal bereitgestellt ist.

3. CVD-Vorrichtung (10) nach Anspruch 1 oder 2, wobei der Abgas-Rückführungskanal (36) mit einem Kompressor (42) zur Erhöhung eines Druckes eines Abgases und zur Rückführung des Abgases zu der Stromaufseite des Abgaskanals bereitgestellt ist.

4. CVD-Vorrichtung (10) nach einem der Ansprüche 1 bis 3, wobei der Abgas-Rückführungskanal (36) mit einer Steuereinrichtung zum Erfassen einer Komponente des Abgases, das zu der Stromaufseite des Abgaskanals rückgeführt wird und zum Bewirken, dass die Gaskomponente konstant ist, ausgebildet ist.

5. CVD-Vorrichtung (10) nach einem der Ansprüche 1 bis 4, wobei der Abgas-Rückführungskanal (36) mit einer Druckablasseinrichtung zum Ablassen eines Druckes, wenn der Abgas-Rückführungskanal einen konstanten Druck oder mehr aufweist, ausgebildet ist.

6. CVD-Vorrichtung (10) nach einem der Ansprüche 1 bis 5, die ferner eine Schaltvorrichtung (58, 62) zum Schalten des Abgas-Rückführungskanals (36) und eines Reaktivgas-Zuführungskanals (26) aufweist, wobei die Schaltvorrichtung eingerichtet ist, um eine Schaltsteuerung so auszuführen, dass der Abgas-Rückführungskanal geöffnet wird, wenn ein Reinigungsgas durch den Reaktivgas-Zuführungskanal in die Reaktionskammer (12) einzuführen ist, wodurch der innere Teil bzw. Bereich gereinigt wird, und die Schaltvorrichtung eingerichtet ist, um den Abgas-Rückführungskanal zu schließen, wenn ein abgeschiedener Film auf einer Oberfläche des Basismaterials (A) in der Reaktionskammer gebildet werden soll.

7. CVD-Vorrichtung (10) nach einem der Ansprüche 1 bis 5, die ferner eine Schaltvorrichtung (58, 62) zum Schalten des Abgas-Rückführungskanals (36) und eines Reaktivgas-Zuführungskanals (26) aufweist, wobei die Schaltvorrichtung eingerichtet ist, um eine Schaltsteuerung so auszuführen, dass der Abgas-Rückführungskanal geöffnet wird, wenn ein Reinigungsgas durch eine entfernte Plasmaerzeugungsvorrichtung (70, 74) in die Reaktionskammer (12) einzuführen ist, wodurch der innere Teil gereinigt wird, und die Schaltvorrichtung eingerichtet ist, eine Schaltsteuerung durchzuführen um den Abgas-Rückführungskanal zu schließen, wenn ein abgeschiedener Film auf einer Oberfläche des Basismaterials (A) in der Reaktionskammer gebildet werden soll.

8. CVD-Vorrichtung (10) nach einem der vorstehenden Ansprüche, wobei die Schaltvorrichtung (52, 58, 60, 62) eingerichtet ist, um eine Schaltsteuerung so auszuführen, dass der Reaktivgas-Zuführungskanal (26) geöffnet wird und falls notwendig der Abgas-Rückführungskanal (36) und der Reaktionskammer-Rückführungskanal (32) in einer Anfangsphase der Reinigung geöffnet werden, und wobei die Schaltvorrichtung eingerichtet ist, eine Schaltsteuerung auszuführen, um den Reaktivgas-Zuführungskanal zum Ausführen der Reinigung nach dem Reinigungsverlauf bzw. dem Fortschreiten der Reinigung zu schließen.

9. CVD-vorrichtung (10) nach einem der Ansprüche 1 bis 7, wobei die Schaltvorrichtung (52, 58, 60, 62) eingerichtet ist, um eine Schaltsteuerung so auszuführen, dass ein Reinigungsgas- Zuführungskanal (30) von einer entfernten Plasmaerzeugungsvorrichtung (70, 74) geöffnet wird und falls notwendig der Abgas-Rückführungskanal (36) und der Reaktionskammer-Rückführungskanal (32) in einer Anfangsphase der Reinigung geöffnet werden, und wobei die Schaltvorrichtung eingerichtet ist, um eine Schaltsteuerung so auszuführen, dass der Reinigungsgas-Zuführungskanal zum Ausführen der Reinigung nach dem Reinigungsverlauf geschlossen ist bzw. wird.

10. CVD-Vorrichtung (10) nach einem der vorstehenden Ansprüche, wobei ein Reinigungsgas, das verwendet wird zur Entfernung eines Nebenprodukts, das in der Reaktionskammer (12) anhaftet, nachdem ein Filmbildungsverfahren für ein Substrat durch die CVD-Vorrichtung durchgeführt wurde, ein Fluorgas enthaltendes Reinigungsgas ist.

11. Verfahren zur Reinigung einer CVD-Vorrichtung (10), wobei ein Reaktivgas bzw. Reaktionsgas in eine Reaktionskammer (12) durch einen Reaktivgaszuführungskanal bzw. -weg (26) zugeführt wird, und ein abgeschiedener Film auf einer Oberfläche eines Basismaterials (A), das in der Reaktionskammer bereitgestellt ist, gebildet wird, und ein innerer Bereich der Reaktionskammer dann gereinigt wird, wobei ein Abgas in ein Plasma umgewandelt wird, und das Abgas zu einer Stromaufseite bzw. stromaufwärtigen Seite einer Trockenpumpe (14) auf einem Abgaskanal (16) über einen Abgas-Rückführungskanal (36) rückgeführt bzw. recycelt wird, wobei der Abgas-Rückführungskanal (36) von
einer Stromabseite bzw. stromabwärtigen Seite der Trockenpumpe und einer Stromaufseite einer Toxizitätsentfernungsvorrichtung (13) auf dem Abgaskanal zum Absaugen bzw. Ablassen eines Gases aus dem inneren Teil der Reaktionskammer durch die Trockenpumpe und die Toxizitätsentfernungsvorrichtung abgezweigt wird, so dass ein innerer Bereich einer Rohrleitung bzw. eines Rohrleitungssystems gereinigt wird, wobei
ein Reaktionskammerrückführungskanal (32) zur Rückführung von Abgas zu der Reaktionskammer auf dem Abgas-Rückführungskanal bereitgestellt bzw, vorgesehen ist, und wobei der innere Teil der Reaktionskammer durch den Reaktionskammerrückführungskanal gereinigt wird.

12. Verfahren zur Reinigung einer CVD-Vorrichtung (10) nach Anspruch 11, wobei eine Polymerfilmvorrichtung (40) zum Absorbieren und Entfernen eines inaktiven Gases in dem Abgas auf dem Abgas-Rückführungskanal (36) bereitgestellt ist.

13. Verfahren zur Reinigung einer CVD-Vorrichtung (10) nach einem der Ansprüche 11 oder 12, wobei ein Separator (44) zur wahlweisen Entfernung einer unnötigen Abgaskomponente auf dem Abgas-Rückführungskanal (36) bereitgestellt ist.

14. Verfahren zur Reinigung einer CVD-Vorrichtung (10) nach einem der Ansprüche 11 bis 13, wobei der Abgas-Rückführungskanal (36) mit einem Kompressor (42) ausgebildet ist, um einen Druck des Abgases zu erhöhen und das Abgas zu der Stromaufseite des Abgaskanals (16) zurückzuführen.

15. Verfahren zur Reinigung einer CVD-Vorrichtung (10) nach einem der Ansprüche 11 bis 14, wobei der Abgas-Rückführungskanal (36) mit einer Steuereinrichtung zur Erfassung einer Komponente, die auf die Stromaufseite des Abgaskanals (16) zurückgeführt ist bzw. wird, und zu Bewirken, dass die Gaskomponente konstant ist, vorgesehen ist.

16. Verfahren zur Reinigung einer CVD-Vorrichtung (10) nach einem der Ansprüche 11 bis 15, wobei der Abgas-Rückführungskanal (36) mit einer Druckablassvorrichtung (50) zum Ablassen eines Drucks, wenn der Abgas-Rückführungskanal (36) einen konstanten Druck oder mehr aufweist, ausgebildet ist.

17. Verfahren zur Reinigung einer CVD-Vorrichtung (10) nach einem der Ansprüche 11 bis 16, wobei der Reaktivgas-Zuführungskanal (26) geöffnet wird und der Abgas-Rückführungskanal (36) und der Reaktionskammer-Rückführungskanal (32) geöffnet werden, falls dies notwendig ist, während eines Anfangsstadiums der Reinigung während der Reinigung, und der Reaktivgas-Zuführungskanal geschlossen wird, um die Reinigung auszuführen, nachdem die Reinigung fortschreitet.

18. Verfahren zur Reinigung einer CVD-Vorrichtung (10) nach einem der Ansprüche 10 bis 16, wobei, wenn ein Reinigungsgas in die Reaktionskammer (12) durch eine entfernte Plasmaerzeugungsvorrichtung (70, 74) eingeführt werden soll, um so einen inneren Bereich der Reaktionskammer zu reinigen, ein Reinigungsgas-Zuführungskanal (30) von der entfernten Plasamerzeugungsvorrichtung geöffnet wird, und der Abgas-Rückführungskanal (36) und der Reaktionskammerrückführungskanal (32) geöffnet werden, falls dies nötig ist, in einem Anfangsstadium der Reinigung und
der Reaktivgaszuführungskanal (26) geschlossen wird, um die Reinigung durchzuführen, nachdem die Reinigung fortschreitet.

19. Verfahren zur Reinigung einer CVD-Vorrichtung (10) nach einem der Ansprüche 11 bis 18, wobei, nachdem ein Filmbildungsverfahren für ein Substrat durch die CVD-Vorrichtung ausgeführt wird, ein Reinigungsgas, welches zur Entfernung eines Nebenprodukts, welches in der Reaktionskammer (12) anhaftet, verwendet werden soll, ein Fluorgas enthaltendes Reinigungsgas ist.

## Revendications

1. Appareil CVD (dépôt chimique en phase vapeur) (10) pour fournir un gaz réactif dans une chambre de réaction (12) et former un film déposé sur une surface d'un matériau de base (A) disposé dans la chambre de réaction,
dans lequel un trajet d'évacuation (16) pour évacuer un gaz par l'intermédiaire d'une pompe sèche (14) et un dispositif d'élimination de toxicité (13) depuis une partie intérieure de la chambre de réaction est muni d'un trajet de recyclage de gaz d'échappement (36) pour recycler le gaz d'échappement, qui est dérivé à partir d'un côté aval de la pompe sèche cet d'un côté amont du dispositif d'élimination de toxicité jusqu'à un côté amont de la pompe sèche sur le trajet d'évacuation,
un dispositif de génération de plasma (33) est disposé sur le trajet de recyclage de gaz d'échappement, et
le trajet de recyclage de gaz d'échappement est muni d'un trajet de recyclage de chambre de réaction (32) pour recycler le gaz d'échappement jusqu'à la chambre de réaction.

2. Appareil CVD (10) selon la revendication 1, dans lequel un séparateur (44) pour retirer sélectivement un composant de gaz d'échappement non nécessaire est disposé sur le trajet de recyclage de gaz d'échappement (36).

3. Appareil CVD (10) selon la revendication 1 ou 2, dans lequel le trajet de recyclage de gaz d'échappement (36) est muni d'un compresseur (42) pour augmenter une pression d'un gaz d'échappement et recycler le gaz d'échappement jusqu'au côté amont du trajet d'évacuation.

4. Appareil CVD (10) selon l'une quelconque des revendications 1 à 3, dans lequel le trajet de recyclage de gaz d'échappement (36) est muni d'un dispositif de commande pour détecter un composant du gaz d'échappement recyclé jusqu'au côté amont du trajet d'évacuation et amener le composant gazeux à être constant.

5. Appareil CVD (10) selon l'une quelconque des revendications 1 à 4, dans lequel le trajet de recyclage de gaz d'échappement (36) est muni d'un dispositif de décharge de pression pour décharger une pression lorsque le trajet de recyclage de gaz d'échappement a une pression constante ou supérieure.

6. Appareil CVD (10) selon l'une quelconque des revendications 1 à 5, comprenant en outre un dispositif de commutation (58, 62) pour commuter le trajet de recyclage de gaz d'échappement (36) et un trajet d'alimentation en gaz réactif (26), dans lequel le dispositif de commutation est conçu pour exécuter une commande de commutation de sorte que le trajet de recyclage de gaz d'échappement est ouvert lorsqu'un gaz de nettoyage doit être introduit, via le trajet d'alimentation en gaz réactif, dans la chambre de réaction (12), dont la partie intérieure est ainsi nettoyée, et le dispositif de commutation est conçu pour exécuter une commande de commutation pour fermer le trajet de recyclage de gaz d'échappement lorsqu'un film déposé doit être formé sur une surface d'un matériau de base (A) dans la chambre de réaction.

7. Appareil CVD (10) selon l'une quelconque des revendications 1 à 5, comprenant en outre un dispositif de commutation (58, 62) pour commuter le trajet de recyclage de gaz d'échappement (36) et un trajet d'alimentation en gaz réactif (26), dans lequel le dispositif de commutation est conçu pour exécuter une commande de commutation de sorte que le trajet de recyclage de gaz d'échappement est ouvert lorsqu'un gaz de nettoyage doit être introduit, via un dispositif de génération de plasma à distance (70, 74), dans la chambre de réaction (12), dont la partie intérieure est ainsi nettoyée, et le dispositif de commutation est conçu pour exécuter une commande de commutation pour fermer le trajet de recyclage de gaz d'échappement lorsqu'un film déposé doit être formé sur la surface du matériau de base (A) dans la chambre de réaction.

8. Appareil CVD (10) selon l'une quelconque des revendications précédentes, dans lequel le dispositif de commutation (52, 58, 60, 62) est conçu pour exécuter une commande de commutation de sorte que le trajet d'alimentation en gaz réactif (26) est ouvert et le trajet de recyclage de gaz d'échappement (36) et le trajet de recyclage de chambre de réaction (32) sont ouverts si nécessaire lors d'une étape initiale du nettoyage, et dans lequel le dispositif de commutation est conçu pour exécuter une commande de commutation pour fermer le trajet d'alimentation en gaz réactif pour effectuer le nettoyage, après progression du nettoyage.

9. Appareil CVD (10) selon l'une quelconque des revendications 1 à 7, dans lequel le dispositif de commutation (56, 58, 60, 62) est conçu pour exécuter une commande de commutation de sorte qu'un trajet d'alimentation en gaz de nettoyage (30) à partir d'un dispositif de génération de plasma à distance (70, 74) est ouvert et le trajet de recyclage de gaz d'échappement (36) et le trajet de recyclage de chambre de réaction (32) sont ouverts si nécessaire lors d'une étape initiale du nettoyage, et dans lequel le dispositif de commutation est conçu pour exécuter une commande de commutation pour fermer le trajet d'alimentation en gaz de nettoyage pour effectuer le nettoyage, après progression du nettoyage.

10. Appareil CVD (10) selon l'une quelconque des revendications précédentes, dans lequel un gaz de nettoyage utilisé pour retirer un sous-produit ayant adhéré dans la chambre de réaction (12) après qu'un processus de formation de film pour un substrat a été exécuté par le dispositif CVD, est un gaz de nettoyage contenant un gaz de fluor.

11. Procédé de nettoyage d'un appareil CVD (10) dans lequel un gaz réactif est fourni dans une chambre de réaction (12) via un trajet d'alimentation en gaz réactif (26) et un film déposé est formé sur une surface d'un matériau de base (A) disposé dans la chambre de réaction, et une partie intérieure de la chambre de réaction est ensuite nettoyée,
dans lequel un gaz d'échappement est converti en un plasma et le gaz d'échappement est recyclé jusqu'à un côté amont d'une pompe sèche (14) sur un trajet d'évacuation (16) via un trajet de recyclage de gaz d'échappement (36), qui est dérivé à partir d'un côté aval de la pompe sèche et d'un côté amont d'un dispositif d'élimination de toxicité (13) sur le trajet d'évacuation pour évacuer un gaz de la partie intérieure de la chambre de réaction, via la pompe sèche et le dispositif d'élimination de toxicité, de sorte qu'une partie intérieure d'une canalisation est nettoyée,
un trajet de recyclage de chambre de réaction (32) pour recycler le gaz d'échappement jusqu'à la chambre de réaction est prévu sur le trajet de recyclage de gaz d'échappement, et
la partie intérieure de la chambre de réaction est nettoyée via le trajet de recyclage de chambre de réaction.

12. Procédé de nettoyage d'un appareil CVD (10) selon la revendication 11, dans lequel un dispositif à film polymère (40) pour absorber et retirer un gaz inactif dans le gaz d'échappement est disposé sur le trajet de recyclage de gaz d'échappement (36).

13. Procédé de nettoyage d'un appareil CVD (10) selon la revendication 11 ou 12, dans lequel un séparateur (44) pour retirer sélectivement un composant de gaz d'échappement non nécessaire est disposé sur le trajet de recyclage de gaz d'échappement (36).

14. Procédé de nettoyage d'un appareil CVD (10) selon l'une quelconque des revendications 11 à 13, dans lequel le trajet de recyclage de gaz d'échappement (36) est muni d'un compresseur (42) pour augmenter une pression du gaz d'échappement et recycler le gaz d'échappement jusqu'au côté amont du trajet d'évacuation (16).

15. Procédé de nettoyage d'un appareil CVD (10) selon l'une quelconque des revendications 11 à 14, dans lequel le trajet de recyclage de gaz d'échappement (36) est muni d'un dispositif de commande pour détecter un composant du gaz d'échappement recyclé jusqu'au côté amont du trajet d'évacuation (16) et amener le composant gazeux à être constant.

16. Procédé de nettoyage d'un appareil CVD (10) selon l'une quelconque des revendications 11 à 15, dans lequel le trajet de recyclage de gaz d'échappement (36) est muni d'un dispositif de décharge de pression (50) pour décharger une pression lorsque le trajet de recyclage de gaz d'échappement a une pression constante ou supérieure.

17. Procédé de nettoyage d'un appareil CVD (10) selon l'une quelconque des revendications 11 à 16, dans lequel le trajet d'alimentation en gaz réactif (26) est ouvert et le trajet de recyclage de gaz d'échappement (36) et le trajet de recyclage de chambre de réaction (32) sont ouverts si nécessaire lors d'une étape initiale du nettoyage, pendant le nettoyage, et
le trajet d'alimentation en gaz réactif est fermé pour effectuer le nettoyage, après progression du nettoyage.

18. Procédé de nettoyage d'un appareil CVD (10) selon l'une quelconque des revendications 11 à 16, dans lequel lorsqu'un gaz de nettoyage doit être introduit dans la chambre de réaction (12) via un dispositif de génération de plasma à distance (70, 74), en nettoyant ainsi une partie intérieure de la chambre de réaction, un trajet d'alimentation en gaz de nettoyage (30) à partir du dispositif de génération de plasma à distance est ouvert et le trajet de recyclage de gaz d'échappement (36) et le trajet de recyclage de chambre de réaction (32) sont ouverts si nécessaire lors d'une étape initiale du nettoyage, et
le trajet d'alimentation en gaz réactif (26) est fermé pour effectuer le nettoyage, après progression du nettoyage.

19. Procédé de nettoyage d'un appareil CVD (10) selon l'une quelconque des revendications 11 à 18, dans lequel, après qu'un processus de formation de film pour un substrat a été exécuté par l'appareil CVD, un gaz de nettoyage à utiliser pour retirer un sous-produit ayant adhéré dans la chambre de réaction (12) est un gaz de nettoyage contenant un gaz de fluor.
